(19)

Europäisches
Patentamt
European
Patent Office
Office européen
des brevets

(11) **EP 1 515 429 B1**

(12) **EUROPEAN PATENT SPECIFICATION**

(45) Date of publication and mention
of the grant of the patent:
**20.08.2008 Bulletin 2008/34**

(51) Int Cl.:
***H03D 3/00*** *(2006.01)*

(21) Application number: **04103956.1**

(22) Date of filing: **18.08.2004**

(54) **Direct conversion receiver and receiving method**

Direktkonversionsempfänger und Verfahren dazu

Récepteur à conversion directe et méthode de récéption

(84) Designated Contracting States:
**AT BE BG CH CY CZ DE DK EE ES FI FR GB GR
HU IE IT LI LU MC NL PL PT RO SE SI SK TR**

(30) Priority: **25.08.2003 FI 20031194
27.10.2003 US 693608**

(43) Date of publication of application:
**16.03.2005 Bulletin 2005/11**

(73) Proprietor: **Nokia Corporation
02150 Espoo (FI)**

(72) Inventors:
• **Koskela, Julius
00400 Helsinki (FI)**

• **Lokio, Jouko
02610 Espoo (FI)**
• **Scheck, Hans-Otto
02360 Espoo (FI)**

(74) Representative: **Niemi, Hakan Henrik
Kolster Oy AB
Iso Roobertinkatu 23
P.O. Box 148
00121 Helsinki (FI)**

(56) References cited:
**EP-A- 0 948 128          EP-A- 1 172 928
EP-A- 1 241 779          EP-A- 1 298 791
US-A1- 2003 072 393     US-B1- 6 356 747
US-B1- 6 552 995**

Note: Within nine months of the publication of the mention of the grant of the European patent in the European Patent Bulletin, any person may give notice to the European Patent Office of opposition to that patent, in accordance with the Implementing Regulations. Notice of opposition shall not be deemed to have been filed until the opposition fee has been paid. (Art. 99(1) European Patent Convention).

**Description**

BACKGROUND OF THE INVENTION:

Field of the Invention:

The invention relates to a direct conversion receiver and a reception method in direct conversion receivers. The invention relates particularly to removal of IQ (In-phase/Quadrature) phase imbalance in direct conversion receivers.

Description of the Related Art:

The use of digital wireless communication systems has recently been increasing. Systems of many different types have been introduced. For example, systems like Wireless LANs (Local Area Networks), UMTS (Universal Mobile Telecommunications System) and GSM (Global System for Mobile Communication) are gaining more attention and users are given more alternatives in wireless communication. To get customers interested in new services it is essential that the equipment needed in order to use the services should be priced correctly. Less expensive receivers having low power consumption are thus needed.

One solution to provide affordable receivers with low power consumption is to use a direct conversion analog front-end architecture in the receivers. In the direct conversion solution, a received RF signal is mixed directly into the base band and thereafter analog-to-digital converted. For the mixing process, two signals, a sine and a cosine signal, have to be provided. Because of technical reasons the precise orthogonality of both sinusoidal signals cannot be guaranteed; therefore an angle $\varphi \neq 90°$ is measurable between the sine and cosine functions. This phenomenon is commonly called IQ phase imbalance.

Analog base band components, such as low-pass filters and baseband amplifiers are installed twice: one component for the I- branch and one component for the Q-branch. Because of manufacturing tolerances, or temperature influences, each component of a certain functional type may behave slightly differently compared with its counterpart on the other branch. The conjunction of frequency dependent base band devices with the constant IQ phase imbalance imperfections result in frequency selective IQ phase imbalance inaccuracies.

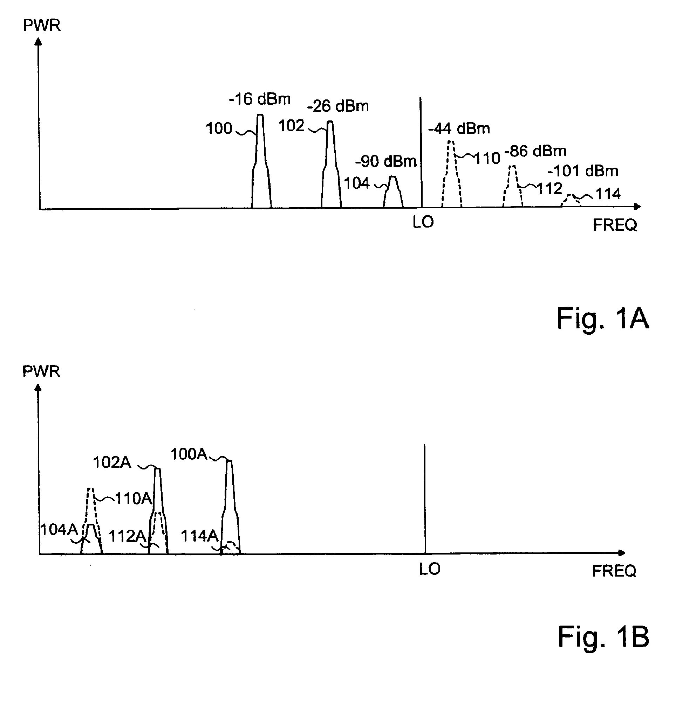

Because of the IQ imbalance, so-called image signals are created at image frequencies of the actual signals, causing IQ-cross talk. Figures 1A and 1B show an example of the reception of a multi-carrier signal under the effect of IQ imbalance. As shown in Figure 1A, the received signal contains six carriers 100 to 114, out of which carriers 100 to 104 form the lower sideband and carriers 110 to 114 above the local oscillator (LO) frequency form the upper sideband. Figure 1B shows how the signal spectrum of Figure 1A may look after frequency conversion to base band when sufficient image rejection is not performed. In the situation shown by Figure 1B, image signals 110A-114A overlap the converted signals 100A-104A.

For example, in case of two carriers with significant power difference in the received signal, an image of the first component appears in the second component and vice versa. The strengths of the image signals depend on the degree of the imbalance and on the strengths of the signals. Weak image signals are usually not a problem when the signal components have approximately the same magnitude. However, problems may arise when one signal is strong and the other signal is weak. If the image of the strong signal is stronger than the weak signal, or even comparable to it, the reception of the weak signal is degraded or even entirely prevented. In the example of Figure 1B, image signal 110A of signal 110 is stronger than the weak signal 104A which may prevent reception of signal 104A.

US 2003/0072393 shows a prior art receiver using quadrature demodulation, FFT processing and I/Q balancing.

SUMMARY OF THE INVENTION:

According to one embodiment, the invention provides a receiving method and a receiver so that IQ imbalance is reduced thus enhancing reception of weak signal components. According to the invention, there is provided a receiving method in a direct conversion receiver. The method includes the steps of receiving, mixing, converting, measuring, estimating, and compensating. The steps of receiving receives a signal including multiple components at different receiving frequencies belonging to a frequency band. The mixing step mixes each of the received signal components into a corresponding base band signal including I- and Q branches. The converting step converts the analog base band signal into a digital signal. The method also measures power levels of the signal components in the digital signal in pairs, where one component in the pair belongs to an upper sideband of the frequency band and one component in the pair belongs to a lower sideband of the frequency band. The method estimates, when either the upper sideband component or the lower sideband component dominates in power over the other component in the pair, a frequency-independent phase imbalance, a frequency-dependent phase imbalance and a gain imbalance. The method compensates the estimated frequency-independent phase imbalance, the frequency-dependent phase imbalance and the gain imbalance to at least one of the I- and Q-branch signals.

The invention also relates to a direct conversion receiver including a receiving mechanism, a mixing mechanism converting mechanism, measuring mechanism, estimating mechanism, and compensating mechanism. The receiving mechanism receives a signal including multiple components at different receiving frequencies belonging to a frequency band. The mixing mechanism mixes each of the received signal components into a corresponding base band signal including I- and Q branches. The converting mechanism converts the analog base band signal into a digital signal. The receiver includes the measuring mechanism for measuring power levels of the signal components in the digital signal in pairs, where one component in the pair belongs to an upper sideband of the frequency band and one component in the pair belongs to a lower sideband of the frequency band. The receiver includes the estimating mechanism for estimating, when either the upper sideband component or the lower sideband component dominates in power over the component in the pair, a frequency-independent phase imbalance, a frequency-dependent phase imbalance and a gain imbalance. The receiver includes compensating mechanism for compensating the estimated frequency-independent phase imbalance, the frequency-dependent phase imbalance and the gain imbalance to at least one of the I- and Q-branch signals.

The invention provides a direct conversion receiver, including a receiver, a mixer, an analog-to-digital converter, a measuring unit, an estimator, and a compensator. The receiver receives a signal including multiple components at different receiving frequencies belonging to a frequency band. The mixer mixes each of the received signal components into a corresponding base band signal including I- and Q branches. The analog-to-digital converter converts the analog base band signal into a digital signal. The receiver also includes a measuring unit to measure power levels of the signal components in the digital signal in pairs, where one component in the pair belongs to an upper sideband of the frequency band and one component in the pair belongs to a lower sideband of the frequency band. The estimator estimates, when either the upper sideband component or the lower sideband component dominates in power over the component in the pair, a frequency-independent phase imbalance, a frequency-dependent phase imbalance and a gain imbalance. The compensator compensates the estimated frequency-independent phase imbalance, the frequency-dependent phase imbalance and the gain imbalance to at least one of the I- and Q-branch signals.

According to one embodiment, invention thus relates to direct-conversion receivers, where a received RF signal may be directly mixed into a base band signal without analog down-conversion to intermediate frequency (IF). The analog base band signal may thereafter be analog-to-digital converted. In the invention, the IQ-phase imbalance may be determined and the correction for the imbalance may be performed into a digital base band signal.

A multicarrier signal can be divided into pairs occupying the same (positive and negative) base band frequency bands as shown in Figure 1A. For example, in situation of Figure 1A, there are 6 carriers and correspondingly there are then 3 carrier pairs. According to one embodiment of the invention, power levels of the received signal components are measured and the estimation for the IQ imbalance are performed pair wise when and only when either the upper or the lower sideband signal component of the carrier pair dominates over the other component. Once estimation has been carried out, compensation can but does not need to be carried out when signals have comparable power.

Estimation for each pair can be carried out independently, i.e., estimation can be done for pair #1 if one of two carriers in it dominates, and likewise for pairs #2 and #3. In one embodiment, the I- and Q-signals may be transformed into frequency domain, and the estimation of IQ imbalance may be based on phase of the cross-spectrum of the transformed signals.

The inventive algorithm and apparatus can be implemented so that one of the signal branches, I and Q, is kept constant, and the phase imbalance is estimated in relation to the branch that is kept constant. In one embodiment, component-specific frequency-dependent phase imbalance estimates may be formed and the frequency-independent phase imbalance may be estimated as average of the component-specific estimates. In one embodiment, the frequency-dependent phase imbalance is estimated as half of the difference between the component-specific, frequency-dependent phase imbalance estimates.

According to one embodiment of the invention, the gain imbalance and the frequency-dependent phase imbalance may be compensated for by digital filtering, and a frequency-independent phase error may be removed by subtracting one of the suitably weighted signal branches I and Q from the other branch signal.

The invention can in an advantageous manner compensate for the frequency-dependent IQ imbalance thus reducing disadvantages of IQ cross talk.

BRIEF DESCRIPTION OF THE DRAWINGS:

In the following, the invention will be described in greater detail with reference to the preferred embodiments and the accompanying drawings, in which

Figure 1A illustrates reception of a multicarrier signal;

Figure 1B shows the effect of the image signals in the frequency domain;

Figure 2A shows one embodiment of the method according to the invention;

Figure 2B specifies the method disclosed in Figure 2A; and

Figure 3 illustrates an example of a direct conversion receiver according to an embodiment of the invention.

DETAILED DESCRIPTION OF THE PREFERRED EMBODIMENTS:

The embodiments of the invention can be applied in any data transmission system employing direct conversion receivers. Examples of such systems include Wireless LANs, UMTS and GSM. A direct conversion receiver is a receiver where a received radio frequency (RF) signal is converted directly to a base band frequency without any intermediate frequency (IF) conversion in between.

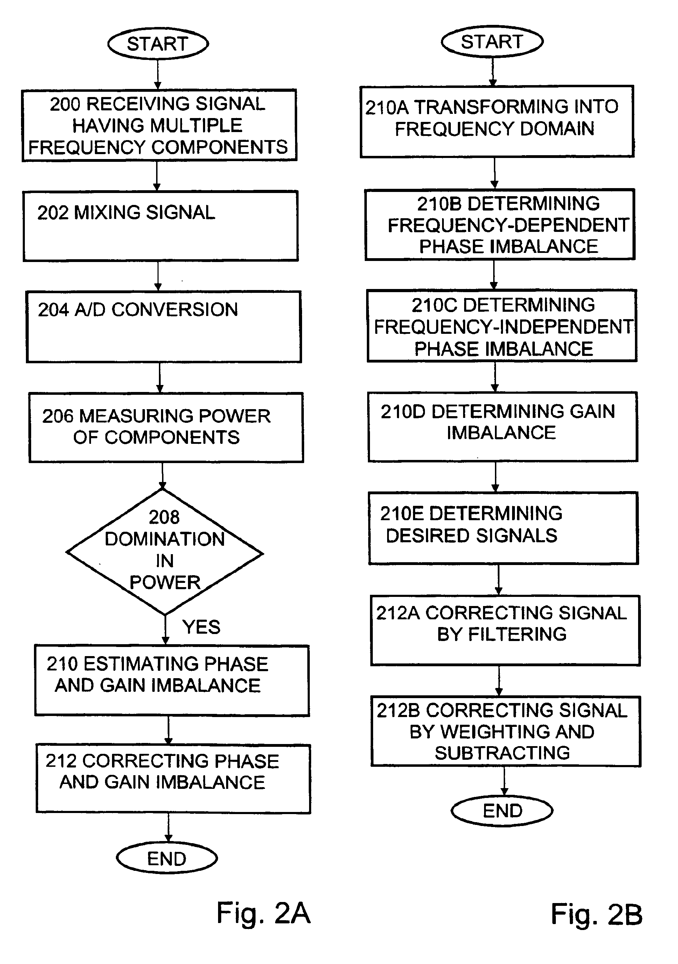

Figures 2A and 2B disclose one embodiment of the method according to the invention. In Figure 2A step 200, a signal having multiple frequency components is received. The signal can thus originate from a single source or can contain multiple carriers from independent sources. The IQ imbalance problem will here be explained using dual-carrier scenario as an example. However, both the problem and the compensation algorithm can be straightforwardly generalized to scenarios with more than two carriers.

The terms $v_{I1}(t)$ and $v_{Q1}(t)$ denote the base band in-phase and quadrature-phase components of the signal 1, respectively, and the terms $v_{I2}(t)$ and $v_{Q2}(t)$ represent the respective components of the signal 2. The frequency bands of the signals may be located symmetrically around the local oscillator (LO) frequency $f_{LO}$. The carrier 1 has thus the frequency $f_{LO}+f_0$ and the carrier 2 has the frequency $f_{LO}-f_0$.

In the receiving step 200, the dual-carrier signal entering the RF port of the receiver further goes through a bandpass filter and a low-noise amplifier. Then the signal is down-converted, that is, mixed into base band signal in a quadrature demodulator according to step 202. The resulting I- and Q-branch signals can be low-pass filtered, amplified, and converted into a digital signal according to step 204. If the receiver is ideal, the signals $v_I(t)$ and $v_Q(t)$ in the output of the ADC's (Analog-to-Digital Converter) have the form shown by Equations (1):

$$\text{Equations} \quad (1)$$

$$i(t) = [v_{I1}(t) + v_{I2}(t)]\cos(2\pi f_0 t) - [v_{Q1}(t) - v_{Q2}(t)]\sin(2\pi f_0 t)$$

$$q(t) = [v_{I1}(t) - v_{I2}(t)]\sin(2\pi f_0 t) + [v_{Q1}(t) + v_{Q2}(t)]\cos(2\pi f_0 t)$$

For clarity of the presentation, phase offset between the RF signal and the LO may be ignored as being irrelevant. To resolve the signals 1 and 2, the digital signals i(t) and q(t) may be subjected to another quadrature down-conversion, in which they are mixed with signals $\cos(2\pi f_0 t)$ and $\sin(2\pi f_0 t)$. Lowpass-filtering the mixing products and combining them appropriately yields the desired signals $v_{I1}(t)$, $v_{Q1}(t)$, $v_{I2}(t)$ and $v_{Q2}(t)$.

The receiver now has some IQ imbalance. Part of the imbalance arises from the I- and Q-branch LO signals differing from perfect phase quadrature. In this discussion, the imbalance is called frequency-independent phase imbalance. In addition to the frequency-independent phase imbalance, there may be frequency-dependent deviations in the gain and phase responses of the I- and Q-branch mixers, low-pass filters, and other analog components. Without loss of generality, one may take the Q-branch of the receiver as reference and assume that all nonideality occurs in the I-branch only.

In Figure 2A in step 206, powers of signal components are measured. In step 208, powers of the signal components on the opposite sides of the LO frequency may be pair-wise compared to each other. When one of the signal components in the pair dominates in power over the other signal component in the pair, the method then estimates the phase and gain imbalance according to step 210. The estimation provides the correcting step 212 with correction factors to correct the phase and gain imbalance.

Figure 2B specifies the estimating and correcting steps of Figure 2A according to one embodiment of the invention. For analysis purposes, it is more convenient to express the signals in frequency domain, the transformation from time to frequency domain being performed in step 210A. The transformation can be performed e.g. with Fast Fourier transform or discrete Fourier transform.

Let I(f) and Q(f) denote the Fourier transforms of the ideal signals i(t) and q(t), and let X(f) and Y(f), shown by Equations (2), denote the corresponding signals in the presence of IQ imbalance

$$\text{Equations} \quad (2)$$

$$X(f) = \Delta g(f) \exp(j\phi(f)) \{\cos(\delta) I(f) + \sin(\delta) Q(f)\},$$

$$Y(f) = Q(f).$$

Here, $\Delta g(f)$ and $\phi(f)$ denote, respectively, gain and phase imbalance as functions of frequency, and $\delta$ represents the phase error between the I- and Q-branch LO signals. When the signals X(f) and Y(f) are subjected to digital down-conversion, the outcome is not only signals 1 and 2. In addition, an image of the signal 1 appears in signal 2 and vice versa. The strengths of the image signals may depend on the degree of the imbalance and on the strengths of the signals.

Note that steps 210A-210D are not limited to the order of steps but on the contrary, these steps can be performed in any order. In the following discussion, the above mentioned dual-carrier scenario is still used as an example. However, the method can be straightforwardly generalized to situations with more than two carriers.

Referring to the IQ imbalance given in Equation (2), it can be seen that if the IQ imbalance parameters $\delta$, $\Delta g$ (f) and $\phi(f)$ are known, estimates I'(f) and Q'(f) for the desired signals I(f) and Q(f), respectively, can be computed from the measured signals X(f) and Y(f) as shown by Equations (3)

$$\text{Equations} \quad (3)$$

$$I'(f) = \exp(-j\phi(f)) / (\cos(\delta) \Delta g(f)) X(f) - \tan(\delta) Y(f),$$

$$Q'(f) = Y(f).$$

In method step 210B, frequency-dependent phase imbalance $\phi(f)$ may be estimated. The estimation may be implemented from the complex-valued frequency-domain signals X(f) and Y(f). Consider a dual-carrier signal of the form (1). The base band signal components $v_{I1}(t)$, $v_{Q1}(t)$, $v_{I2}(t)$ and $v_{Q2}(t)$ forming the dual-carrier signal are assumed to be noise-like in the sense that their Fourier-transforms, $V_{I1}(f)$, $V_{Q1}(f)$, $V_{I2}(f)$ and $V_{Q2}(f)$, respectively, satisfy Equations (4)

$$\text{Equations} \quad (4)$$

$$< V_{Ia}(f) V_{Ib}(f) > = 0, \qquad \text{where } a = 1, 2 \text{ and } b = 1,2,$$

$$< V_{Ia}(f) V_{Qb}(f) > = 0, \qquad \text{where } a = 1, 2 \text{ and } b = 1,2,$$

$$< V_{Qa}(f) V_{Qb}(f) > = 0, \qquad \text{where } a = 1, 2 \text{ and } b = 1,2.$$

Here, notation <Z> denotes the expectation value of the quantity Z, evaluated in practice by averaging the values of Z over several sets of data. Moreover, assume that the signals 1 and 2 are independent, in the sense that they satisfy Equation (5)

$$\text{Equation} \quad (5)$$

$$< V_{a1}(f) V_{b2}^{*}(f) > = 0, \text{ where } a = I, Q \text{ and } b = I, Q.$$

Here, the asterisk * denotes a complex conjugation. The in-phase and quadrature-phase components $v_{I1}(t)$ and $v_{Q1}(t)$ of the signal 1 are not required to be uncorrelated, neither are the components of the signal 2. With some algebraic manipulation, it can be shown that Equation 6 (Equation 6, continues on two lines) applies

Equation  (6)

$$< X(f)Y^*(f) > = j\tfrac{1}{4}\,\Delta g(f)\,\exp(j\phi(f))\,x$$

$$(\exp(-j\delta)(S_1(f_0+f)+S_2(f-f_0))-\exp(j\delta)(S_1(f-f_0)+S_2(f_0+f))).$$

Equation (7) shows $S_1(f)$ and $S_2(f)$ respectively denoting the spectra of the signals 1 and 2:

Equation  (7)

$$S_a(f) = < (V_{Ia}(f) + jV_{Qa}(f))\,(V_{Ia}(f) + jV_{Qa}(f))^* >$$

where a = 1,2.

Assuming that spectra are sufficiently band-limited, the following Equation (8) applies:

Equation  (8)

$$< X(f_0+f)Y^*(f_0+f) > \cong j\,\tfrac{1}{4}\Delta g(f_0+f)\,\exp(j\delta(f_0+f))(\exp(-j\delta)S_2(f)-\exp(j\delta)S_1(f)).$$

Consequently, the signal 1 with RF carrier at frequency $f_{LO}+f_0$, may experience an effective phase imbalance $\varphi_1(f)$, whereas the signal 2, with RF carrier frequency $f_{LO}-f_0$, experiences an effective phase imbalance $\varphi_2(f)$, the phase imbalances are shown by Equations (9)

Equations  (9)

$$\varphi_1(f)= \delta+\Phi(f),$$

$$\varphi_2(f)= \delta-\Phi(f).$$

Hence, the estimation of the phase imbalance from the phase of the averaged quantity $<X(f)Y^*(f)>$ yields considerable advantages. Because of averaging, the phase of cross-products of signals satisfying Equations (4) and (5) may oscillate randomly and rapidly vanish, leaving only contributions proportional to the spectrum of the signals to remain, as shown in Equation (8). Consequently, the correlation between the I- and Q-components of signal 1 or those of signal 2 may only affect the spectrum of those signals and does not influence the phases. Moreover, since the phase of the terms proportional to the spectrum of signals 1 and 2 are independent of the exact shape of the spectra, the signals themselves do not need to be known and the estimation is blind. The algorithm does not require pilot signals or decision-aided feedback. Finally, the phase of the quantity $<X(f)Y^*(f)>$ directly yields phase imbalance data in Fourier domain. Hence, it is not necessary to use loops in time domain, and the method converges remarkably rapidly. A secondary algorithm may be needed to separate the frequency independent and frequency dependent contribution. Several methods to accomplish this separation may be included in this invention.

For example, when both signals 1 and 2 are present, the phase of the averaged quantity $< X(f)Y^*(f) >$ may depend on the relative strengths of the signals. However, under the condition that either $S_1(f) \gg S_2(f)$ or $S_2(f) \gg S_1(f)$, the phase of the averaged quantity $< X(f)Y^*(f) >$ directly yields either the quantity $\varphi_1(f)$ or the quantity $\varphi_2(f)$. Referring back to Figure 2A and steps 206 and 208 the phase imbalance is estimated from the phase of the averaged quantity <

X(f)Y*(f) > only when one of the signals in the signal component pair dominates in receiving power over the other one. In optimal conditions the dominating signal alternates over a reasonable measuring period, i.e., signal 1 may dominate part of the time and signal 2 may dominate part of the time. In such conditions, estimates may be obtained for both quantities $\varphi_1(f)$ and $\varphi_2(f)$. Referring again to Figure 2B and step 210C, the phase error between I and Q LO-signals $\delta$, that is, the frequency independent phase error, can be estimated according to Equation (10) as an average

$$\delta = (\varphi_1(f) + \varphi_2(f))/2 \qquad\qquad \text{Equation} \quad (10)$$

over the frequency band of interest, and frequency-dependent phase error $\Phi(f)$ of step 210B can be estimated according to Equation (11)

$$\Phi(f) = (\varphi_1(f) - \varphi_2(f))/2. \qquad\qquad \text{Equation} \quad (11)$$

Alternatively, for example polynomial fitting methods can be used to extract the imbalances from either quantity $\varphi_1(f)$ or $\varphi_2(f)$ alone.

One approach to achieve the desired alternation in the relative signal powers is to use the RF test loop. In unit testing/calibration stage, signals generated by the RF test loop can be used to achieve initial values for the imbalance. During operation, if there are time periods when only one of the signals is being received, the RF test loop may be used to generate the other signal for imbalance estimation purposes.

The method can be straightforwardly generalized to cases with more than two carriers. It may then be required that the phase imbalance is estimated only when each frequency band of interest is dominated by only one of the two possible carriers that can occupy that particular frequency band. Decomposition into frequency-dependent and frequency-independent imbalance contribution is then straightforward.

Estimation of gain imbalance $\Delta g(f)$ as shown by step 210D, can be estimated with some prior art method utilizing the signals from ADCs to obtain frequency-domain signals X(f) and Y(f) by Fourier transform according to step. As a result of the Fourier transform, the amplitude levels of each frequency component are determined. Initially, both I- and Q-branch contain both sidebands but with different phases. In the average, the I- and Q-branches have the same power, if both branches are identical. The ratio of the amplitude averages at each frequency point of the I- and Q-branches may reveal the frequency dependent gain difference between the I- and Q-branch of the receiver.

Method steps 210B-210D presented above contribute to the determination of, according to step 210E, the desired signals presented by equations (3). As a practical realization, e.g. a digital equalizer such as a FIR (Finite Impulse Response) filter can be realized so that its frequency response matches the inverse imbalance $\exp(-j\Phi(f)) / (\cos(\delta) \Delta g(f))$. The accuracy of the correction depends on the accuracy of the estimated imbalance parameters. Hence, the algorithm for imbalance estimation may be of crucial importance.

Step 212A uses an equalizer to compensate the gain imbalance and frequency-dependent phase imbalance. As a second correction step, second correction step 212B is introduced, where correction may be performed with a subtraction element compensating the frequency-independent phase imbalance. Tunable delay elements can be added to control overall delay between the I- and Q-branches and to alleviate the filter synthesis.

An alternative solution, in comparison to the one disclosed above, is, not to use delay elements but, instead, to carry out the correction to either I- or Q-branches according to which branch has a shorter delay.

The inventive idea can also be implemented so that LO phase error is compensated by introducing an opposite phase imbalance into the digital oscillator in the base band double quadrature stage which follows the compensation stage.

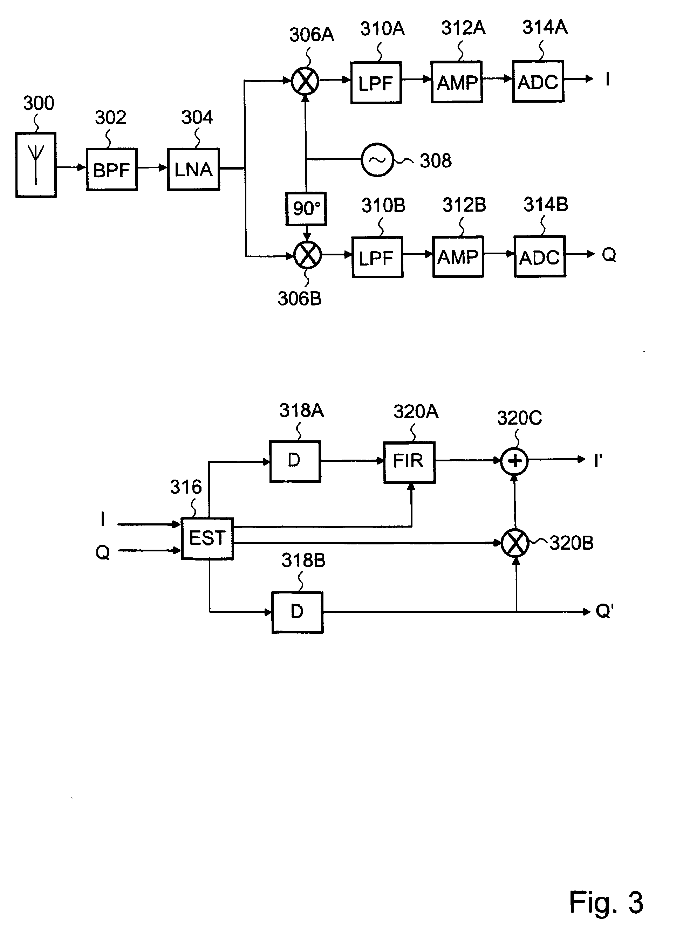

Figure 3 illustrates an example of a receiver according to the invention. The receiver includes a receiving device 300 that includes an antenna, whereby a radio frequency signal from a transmitter is received. The received signal may be band pass filtered in a filter 302 and amplified in a low noise amplifier 304. Then, the signal may be mixed directly into the base band frequency in mixers 306A-306B where local oscillator 308 provides the RF signal used in the mixing. After the mixing process, an analog complex signal s(t) = I(t) + jQ(t), having approximately 90 degrees phase difference between the signal branches, is available. The I- and Q-components may be passed to corresponding analog low pass filters 310A-310B and a base band amplifiers 312A-312B. The signals may then be converted into digital signals in a converting device, that is, A/D converters 314A-314B. These receiver components are all known to one skilled in the art.

In multicarrier systems, IQ phase errors have a significant impact on the signal performance, compared with single carrier radios. It may therefore be important to eliminate the IQ phase imbalance in the receiver as early as possible. In the embodiment illustrated by the receiver of Figure 3, an IQ phase imbalance estimation block 316 may follow directly after the A/D converters 314A-314B. The signal may then be processed by tunable delay elements 318A-318B to control overall delay between the I- and Q-branches and to alleviate the filter synthesis. In the estimation block 316, frequency-dependent phase imbalance $\Phi(f)$, frequency-independent phase imbalance $\delta$ and gain imbalance $\Delta g(f)$ are estimated. Figure 3 shows one example to correct the estimated factors of the total IQ imbalance. The receiver may contain a compensating device, which includes a first correcting device 320A such as a FIR filter to compensate for the frequency-dependent phase imbalance $\Phi(f)$ and the gain imbalance $\Delta g(f)$. The compensating device further contains a subtraction element 320B-320C to subtract the frequency-independent phase imbalance $\delta$ to obtain the compensated signals I'(f) and Q'(f) in equations (3).

The invention can be realized as a DSP (Digital Signal Processing) algorithm. For example, the invention can be implemented together with the other RF-related DSP functions, such as digital down-conversion, filtering and scaling. For example, ASIC (Application Specific Integrated Circuit), FPGA (Field Programmable Gate Arrays) or processor-based approaches can be used.

Even though the invention has been described above with reference to an example according to the accompanying drawings, it is clear that the invention is not restricted thereto but can be modified in several ways within the scope of the appended claims.

**Claims**

1. A receiving method in a direct conversion receiver, the method comprising:

   receiving (200) a signal comprising multiple signal components at different receiving frequencies belonging to a frequency band;
   mixing (202) at least one of the received signal components into a corresponding base band signal comprising I- and Q branches;
   converting (204) the analog base band signal into a digital signal,

   **characterized by**:

   measuring (206) power levels of the signal components in the digital signal in pairs, where a first component in a pair belongs to an upper sideband of the frequency band and a second component in the pair belongs to a lower sideband of the frequency band;
   estimating (210), when either the upper sideband component or the lower sideband component dominates in power over another component in the pair, a frequency-independent phase imbalance, and a frequency-dependent phase imbalance and a gain imbalance;
   compensating (212) the estimated frequency-independent phase imbalance, and the frequency-dependent phase imbalance and the gain imbalance to at least one of the I- and Q-branch signals.

2. The method of claim 1, wherein the step of estimating further comprises:

   transforming the I- and Q-signals into frequency domain using a discrete Fourier transform or a fast Fourier transform to provide signals X(f) and Y(f);
   estimating the frequency-dependent phase imbalance and the frequency-independent phase imbalance from the phase of the cross-spectrum (X(f)Y*(f)),
   wherein X(f) and Y(f) denote the corresponding base band signals.

3. The method of claim 2, wherein the step of estimating comprises estimating the frequency-dependent phase imbalance and the frequency-independent phase imbalance from the phase of the averaged cross-spectrum <X(f)Y*(f)>.

4. The method of claim 1, wherein the step of estimating comprises estimating signal component-specific frequency-dependent phase imbalances when either the upper or the lower sideband signal component present in the pair dominates in power over the another component, and
   estimating the frequency-independent phase imbalance as an average over the component-specific frequency-dependent phase imbalances.

5. The method of claim 1, wherein the step of estimating comprises estimating signal component-specific frequency-dependent phase imbalance factors when either the upper or the lower sideband signal component in the pair dominates in power over the another component; and
   estimating the frequency-dependent phase imbalance as half of a difference between the component-specific frequency-dependent phase imbalance factors.

6. The method of claim 1, wherein the estimating step comprises
estimating signal component-specific frequency-dependent phase imbalances when either the upper or the lower sideband signal component of the pair dominates in power over the another component; and
estimating the frequency-independent phase imbalance from one or several of the component-specific frequency-dependent phase-imbalances by fitting techniques.

7. The method of claim 1, wherein the compensating step comprises compensating for the frequency-dependent phase imbalance and for the gain imbalance by digital filtering.

8. The method of claim 7, wherein the compensating step comprises compensating for the frequency-independent phase imbalance by subtracting the frequency independent phase imbalance from the outcome of the digital filtering.

9. A direct conversion receiver, comprising:

receiving means (300) for receiving a signal comprising multiple signal components at different receiving frequencies belonging to a frequency band;
mixing means (306A, 306B) for mixing at least one of the received signal components into a corresponding base band signal comprising I- and Q branches;
converting means (314A, 314B) for converting the analog base band signal into a digital signal, **characterized in that** the receiver comprises:
measuring means for measuring power levels of the signal components in the digital signal in pairs, where a first component in a pair belongs to an upper sideband of the frequency band and a second component in the pair belongs to a lower sideband of the frequency band;
means for estimating (316), when either the upper sideband component or the lower sideband component dominates in power over another component in the pair, a frequency-independent phase imbalance, and a frequency-dependent phase imbalance and a gain imbalance; and
compensating means (320A, 320B, 320C) for compensating the estimated frequency-independent phase imbalance, and the frequency-dependent phase imbalance and the gain imbalance to at least one of the I- and Q-branch signals.

10. The direct conversion receiver of claim 9, wherein the estimating means is configured to:

transform the I- and Q-signals into frequency domain using discrete Fourier transform or fast Fourier transform to provide signals X(f) and Y(f);
estimate the frequency-dependent phase imbalance and the frequency-independent phase imbalance from the phase of the cross-spectrum (X(f)Y*(f)),
wherein X(f) and Y(f) denote the corresponding base band signals.

11. The direct conversion receiver of claim 10, wherein the estimating means estimates the frequency-dependent phase imbalance and the frequency-independent phase imbalance from the phase of the averaged cross-spectrum <X(f) Y*(f)>.

12. The direct conversion receiver of claim 9, wherein the estimating means is configured to:

estimate signal component-specific frequency-dependent phase imbalances when either upper- or lower sideband signal component present in the pair dominates in power over the another component; and
estimate the frequency-independent phase imbalance as an average over the component-specific frequency-dependent phase imbalances.

13. The direct conversion receiver of claim 9, wherein the estimating means is configured to:

estimate signal component-specific frequency-dependent phase imbalance factors when either the upper- or the lower sideband signal component in the pair dominates in power over the another component; and
estimate the frequency-dependent phase imbalance as a half of the difference between the component-specific frequency-dependent phase imbalance factors.

**14.** The direct conversion receiver of claim 9, wherein the estimating means is configured to:

estimate signal component-specific frequency-dependent phase imbalances when either the upper- or the lower sideband signal component of the pair dominates in power over the another component; and
estimate the frequency-independent phase imbalance from one or several of the component-specific frequency-dependent phase-imbalances by fitting techniques.

**15.** The direct conversion receiver of claim 9, wherein the compensating means is configured to:

compensate for the frequency-dependent phase imbalance and for the gain imbalance by digital filtering.

**16.** The direct conversion receiver of claim 15, wherein the compensating means if configured to:

compensate for the frequency-independent phase imbalance by subtracting the frequency independent phase imbalance from the outcome of the digital filtering.

**Patentansprüche**

**1.** Empfangsverfahren in einem Direktumwandlungsempfänger,
wobei das Verfahren umfasst:

Empfangen (200) eines Signals, das mehrere Signalkomponenten auf verschiedenen Empfangsfrequenzen umfasst, die zu einem Frequenzband gehören;
Mischen (202) wenigstens einer der Empfangssignalkomponenten zu einem entsprechenden Basisbandsignal, das I- und Q-Zweige umfasst;
Umwandeln (204) des analogen Basisbandsignals in ein digitales Signal,
**gekennzeichnet durch:**

Messen (206) von Leistungspegeln der Signalkomponenten im digitalen Signal in Paaren, wobei eine erste Komponente in einem Paar zu einem oberen Seitenband des Frequenzbandes gehört und eine zweite Komponente in dem Paar zu einem unteren Seitenband des Frequenzbandes gehört;
Schätzen (210), wenn entweder die Komponente des oberen Seitenbandes oder die Komponente des unteren Seitenbandes in der Leistung gegenüber einer anderen Komponente in dem Paar vorherrscht, einer frequenzunabhängigen Phasenungleichheit sowie einer frequenzabhängigen Phasenungleichheit und einer Verstärkungsungleichheit;
Ausgleichen (212) der geschätzten frequenzunabhängigen Phasenungleichheit sowie der frequenzabhängigen Phasenungleichheit und der Verstärkungsungleichheit für wenigstens eines der I- und Q-Zweig-Signale.

**2.** Verfahren nach Anspruch 1, wobei der Schritt des Schätzens ferner umfasst:

Transformieren der I- und Q-Signale unter Verwendung einer diskreten Fourier-Transformation oder einer schnellen Fourier-Transformation in den Frequenzbereich, um Signale $X(f)$ und $Y(f)$ bereitzustellen;
Schätzen der frequenzabhängigen Phasenungleichheit und der frequenzunabhängigen Phasenungleichheit aus der Phase des Kreuzspektrums $(X(f)Y^*(f))$,
wobei $X(f)$ und $Y(f)$ die entsprechenden Basisbandsignale bezeichnen.

**3.** Verfahren nach Anspruch 2, wobei der Schritt des Schätzens ein Schätzen der frequenzabhängigen Phasenungleichheit und der frequenzunabhängigen Phasenungleichheit aus der Phase des gemittelten Kreuzspektrums $<X(f)Y^*(f)>$ umfasst.

**4.** Verfahren nach Anspruch 1, wobei der Schritt des Schätzens ein Schätzen von signalkomponentenspezifischen frequenzabhängigen Phasenungleichheiten umfasst, wenn entweder die Signalkomponente des oberen oder des unteren Seitenbandes, die in dem Paar vorhanden ist, in der Leistung gegenüber der anderen Komponente vorherrscht, und
Schätzen der frequenzunabhängigen Phasenungleichheit als einen Mittelwert gegenüber den komponentenspezifischen frequenzabhängigen Phasenungleichheiten.

**5.** Verfahren nach Anspruch 1, wobei der Schritt des Schätzens ein Schätzen von signalkomponentenspezifischen frequenzabhängigen Phasenungleichheitsfaktoren umfasst, wenn entweder die Signalkomponente des oberen oder des unteren Seitenbandes in dem Paar in der Leistung gegenüber der anderen Komponente vorherrscht; und Schätzen der frequenzabhängigen Phasenungleichheit als eine Hälfte einer Differenz zwischen den komponentenspezifischen frequenzabhängigen Phasenungleichheitsfaktoren.

**6.** Verfahren nach Anspruch 1, wobei der Schätzschritt ein Schätzen von signalkomponentenspezifischen frequenzabhängigen Phasenungleichheiten umfasst, wenn entweder die Signalkomponente des oberen oder des unteren Seitenbandes des Paares in der Leistung gegenüber der anderen Komponente vorherrscht; und Schätzen der frequenzunabhängigen Phasenungleichheit aus einer oder mehreren der komponentenspezifischen frequenzabhängigen Phasenungleichheiten durch Anpasstechniken.

**7.** Verfahren nach Anspruch 1, wobei der Ausgleichsschritt ein Ausgleichen der frequenzabhängigen Phasenungleichheit und der Verstärkungsungleichheit durch digitales Filtern umfasst.

**8.** Verfahren nach Anspruch 7, wobei der Ausgleichsschritt ein Ausgleichen der frequenzunabhängigen Phasenungleichheit durch Subtrahieren der frequenzunabhängigen Phasenungleichheit vom Ergebnis des digitalen Filterns umfasst.

**9.** Direktumwandlungsempfänger, umfassend:

Empfangsmittel (300) zum Empfangen eines Signals, das mehrere Signalkomponenten auf verschiedenen Empfangsfrequenzen umfasst, die zu einem Frequenzband gehören; Mischmittel (306A, 306B) zum Mischen wenigstens einer der Empfangssignalkomponenten zu einem entsprechenden Basisbandsignal, das I- und Q-Zweige umfasst; Umwandlungsmittel (314A, 314B) zum Umwandeln des analogen Basisbandsignals in ein digitales Signal, **dadurch gekennzeichnet, dass** der Empfänger umfasst:

Messmittel zum Messen von Leistungspegeln der Signalkomponenten im digitalen Signal in Paaren, wobei eine erste Komponente in einem Paar zu einem oberen Seitenband des Frequenzbandes gehört und eine zweite Komponente in dem Paar zu einem unteren Seitenband des Frequenzbandes gehört; Mittel zum Schätzen (316), wenn entweder die Komponente des oberen Seitenbandes oder die Komponente des unteren Seitenbandes in der Leistung gegenüber einer anderen Komponente in dem Paar vorherrscht, einer frequenzunabhängigen Phasenungleichheit sowie einer frequenzabhängigen Phasenungleichheit und einer Verstärkungsungleichheit; und Ausgleichmittel (320A, 320B, 320C) zum Ausgleichen der geschätzten frequenzunabhängigen Phasenungleichheit sowie der frequenzabhängigen Phasenungleichheit und der Verstärkungsungleichheit für wenigstens eines der I- und Q-Zweig-Signale.

**10.** Direktumwandlungsempfänger nach Anspruch 9, wobei das Schätzmittel so konfiguriert ist, dass es:

die I- und Q-Signale unter Verwendung einer diskreten Fourier-Transformation oder einer schnellen Fourier-Transformation in den Frequenzbereich transformiert, um Signale X(f) und Y(f) bereitzustellen; die frequenzabhängige Phasenungleichheit und die frequenzunabhängige Phasenungleichheit aus der Phase des Kreuzspektrums (X(f)Y*(f)) schätzt, wobei X(F) und Y(f) die entsprechenden Basisbandsignale bezeichnen.

**11.** Direktumwandlungsempfänger nach Anspruch 10, wobei das Schätzmittel die frequenzabhängige Phasenungleichheit und die frequenzunabhängige Phasenungleichheit aus der Phase des gemittelten Kreuzspektrums <X(f)Y*(f)> schätzt.

**12.** Direktumwandlungsempfänger nach Anspruch 9, wobei das Schätzmittel so konfiguriert ist, dass es:

signalkomponentenspezifische frequenzabhängige Phasenungleichheiten schätzt, wenn entweder die Signalkomponente des oberen oder des unteren Seitenbandes, die in dem Paar vorhanden ist, in der Leistung gegenüber der anderen Komponente vorherrscht, und die frequenzunabhängige Phasenungleichheit als einen Mittelwert gegenüber den komponentenspezifischen frequenzabhängigen Phasenungleichheiten schätzt.

**13.** Direktumwandlungsempfänger nach Anspruch 9, wobei das Schätzmittel so konfiguriert ist, dass es:

signalkomponentenspezifische frequenzabhängige Phasenungleichheitsfaktoren schätzt, wenn entweder die Signalkomponente des oberen oder des unteren Seitenbandes in dem Paar in der Leistung gegenüber der anderen Komponente vorherrscht; und
die frequenzabhängige Phasenungleichheit als eine Hälfte der Differenz zwischen den komponentenspezifischen frequenzabhängigen Phasenungleichheitsfaktoren schätzt.

**14.** Direktumwandlungsempfänger nach Anspruch 9, wobei das Schätzmittel so konfiguriert ist, dass es:

signalkomponentenspezifische frequenzabhängige Phasenungleichheiten schätzt, wenn entweder die Signalkomponente des oberen oder des unteren Seitenbandes des Paares in der Leistung gegenüber der anderen Komponente vorherrscht; und
die frequenzunabhängige Phasenungleichheit aus einer oder mehreren der komponentenspezifischen frequenzabhängigen Phasenungleichheiten durch Anpasstechniken schätzt.

**15.** Direktumwandlungsempfänger nach Anspruch 9, wobei das Ausgleichsmittel so konfiguriert ist, dass es:

die frequenzabhängige Phasenungleichheit und die Verstärkungsungleichheit durch digitales Filtern ausgleicht.

**16.** Direktumwandlungsempfänger nach Anspruch 15, wobei das Ausgleichsmittel so konfiguriert ist, dass es:

die frequenzunabhängige Phasenungleichheit durch Subtrahieren der frequenzunabhängigen Phasenungleichheit vom Ergebnis des digitalen Filterns ausgleicht.

## Revendications

**1.** Procédé de réception dans un récepteur de conversion directe, le procédé comprenant les étapes consistant à :

recevoir (200) un signal comprenant de multiples composants de signal à des fréquences de réception différentes appartenant à une bande de fréquence ;
mélanger (202) au moins un composant parmi les composants de signal reçus dans un signal à bande de base correspondant comprenant des branches I et Q;
convertir (204) le signal à bande de base analogue en un signal numérique,
**caractérisé par** les étapes consistant à :

mesurer (206) des niveaux de puissance des composants de signal dans le signal numérique en paires, où un premier composant dans une paire appartient à une bande latérale supérieure de la bande de fréquence et un deuxième composant dans la paire appartient à une bande latérale inférieure de la bande de fréquence ;
estimer (210), lorsque soit le composant de bande latérale supérieure soit le composant de bande latérale inférieure domine en puissance un autre composant dans la paire, un déséquilibre de phase indépendant de la fréquence, et un déséquilibre de phase dépendant de la fréquence et un déséquilibre de gain ;
compenser (212) le déséquilibre de phase indépendant de la fréquence estimé, et le déséquilibre de phase dépendant de la fréquence et le déséquilibre de gain par au moins un signal parmi les signaux de branche I et Q.

**2.** Procédé selon la revendication 1, dans lequel l'étape d'estimation comprend en outre les étapes consistant à :

transformer les signaux I et Q en domaine de fréquence en utilisant une transformée discrète de Fourier ou une transformée rapide de Fourier pour fournir des signaux X(f) et Y(f) ;
estimer le déséquilibre de phase dépendant de la fréquence et le déséquilibre de phase indépendant de la fréquence à partir de la phase de l'interspectre (X(f)Y*(f)),
dans lequel X(f) et Y(f) indiquent les signaux à bande de base correspondants.

**3.** Procédé selon la revendication 2, dans lequel l'étape d'estimation comprend l'étape consistant à estimer le déséquilibre de phase dépendant de la fréquence et le déséquilibre de phase indépendant de la fréquence à partir de la phase de l'interspectre moyennée <X(f)Y*(f)>.

4. Procédé selon la revendication 1, dans lequel l'étape d'estimation comprend l'étape consistant à estimer des déséquilibres de phase dépendants de la fréquence et spécifiques au composant de signal lorsque soit le composant de signal à bande latérale supérieure soit le composant de signal à bande latérale inférieure présent dans la paire domine en puissance l'autre composant, et
estimer le déséquilibre de phase indépendant de la fréquence en tant que moyenne sur les déséquilibres de phase dépendants de la fréquence et spécifiques au composant.

5. Procédé selon la revendication 1, dans lequel l'étape d'estimation comprend l'étape consistant à estimer les facteurs de déséquilibre de phase dépendants de la fréquence et spécifiques au composant de signal lorsque soit le composant de signal à bande latérale supérieure soit le composant de signal à bande latérale inférieure dans la paire domine en puissance un autre composant ; et
estimer le déséquilibre de phase dépendant de la fréquence en tant que moitié d'une différence entre les facteurs de déséquilibre de phase dépendants de la fréquence et spécifiques au composant.

6. Procédé selon la revendication 1, dans lequel l'étape d'estimation comprend l'étape consistant à estimer les déséquilibres de phase dépendants de la fréquence et spécifiques au composant de signal lorsque soit le composant de signal à bande latérale supérieure soit le composant de signal à bande latérale inférieure dans la paire domine en puissance un autre composant ; et
estimer le déséquilibre de phase indépendant de la fréquence à partir d'un ou de plusieurs déséquilibres de phase dépendants de la fréquence et spécifiques au composant à l'aide de technique d'ajustement.

7. Procédé selon la revendication 1, dans lequel l'étape de compensation comprend l'étape consistant à compenser le déséquilibre de phase dépendant de la fréquence et le déséquilibre de gain par filtrage numérique.

8. Procédé selon la revendication 7, dans lequel l'étape de compensation comprend l'étape consistant à compenser le déséquilibre de phase dépendant de la fréquence en soustrayant le déséquilibre de phase indépendant de la fréquence au résultat du filtrage numérique.

9. Récepteur de conversion directe, comprenant :

un moyen de réception (300) destiné à recevoir un signal comprenant de multiples composants de signal à des fréquences de réception différentes appartenant à une bande de fréquence ;
des moyens de mélange (306A, 306B) destinés à mélanger au moins des composants parmi les composants de signal reçus dans un signal à bande de base correspondant comprenant des branches I et Q ;
des moyens de conversion (314A, 314B) destinés à convertir le signal à bande de base analogue en un signal numérique, **caractérisé en ce que** le récepteur comprend :

un moyen de mesure destiné à mesurer des niveaux de puissance des composants de signal dans le signal numérique en paires, où un premier composant dans une paire appartient à une bande latérale supérieure de la bande de fréquence et un deuxième composant dans la paire appartient à une bande latérale inférieure de la bande de fréquence ;
un moyen destiné à estimer (316), lorsque soit le composant à bande latérale supérieure soit le composant à bande latérale inférieure domine en puissance un autre composant dans la paire, un déséquilibre de phase indépendant de la fréquence, et un déséquilibre de phase dépendant de la fréquence et un déséquilibre de gain ; et
des moyens de compensations (320A, 320B, 320C) destinés à compenser le déséquilibre de phase indépendant de la fréquence estimé, et le déséquilibre de phase dépendant de la fréquence et le déséquilibre de gain estimés par au moins un signal parmi les signaux de branche I et Q.

10. Récepteur de conversion directe selon la revendication 9, dans lequel le moyen d'estimation est configuré pour :

transformer les signaux I et Q en domaine de fréquence en utilisant une transformée discrète de Fourier ou une transformée rapide de Fourier pour fournir des signaux X(f) et Y(f) ;
estimer le déséquilibre de phase dépendant de la fréquence et le déséquilibre de phase indépendant de la fréquence à partir de la phase de l'interspectre (X(f)Y*(f)),
dans lequel X(f) et Y(f) indiquent les signaux à bande de base correspondants.

**11.** Récepteur de conversion directe selon la revendication 10, dans lequel le moyen d'estimation estime le déséquilibre de phase dépendant de la fréquence et le déséquilibre de phase indépendant de la fréquence à partir de la phase de l'interspectre moyennée < X(f)Y*(f)>.

**12.** Récepteur de conversion directe selon la revendication 9, dans lequel le moyen d'estimation est configuré pour :

estimer les déséquilibres de phase dépendants de la fréquence et spécifiques au composant de signal lorsque soit le composant de signal à bande latérale supérieure soit le composant de signal à bande latérale inférieure présent dans la paire domine en puissance l'autre composant ; et
estimer le déséquilibre de phase indépendant de la fréquence en tant que moyenne sur les déséquilibres de phase dépendants de la fréquence et spécifiques au composant.

**13.** Récepteur de conversion directe selon la revendication 9, dans lequel le moyen d'estimation est configuré pour :

estimer les facteurs de déséquilibre de phase de phase dépendants de la fréquence et spécifiques au composant de signal lorsque soit le composant de signal à bande latérale supérieure soit le composant de signal à bande latérale inférieure présent dans la paire domine en puissance l'autre composant ; et
estimer le déséquilibre de phase dépendant de la fréquence en tant que moitié de la différence entre les facteurs de déséquilibre de phase dépendants de la fréquence et spécifiques au composant.

**14.** Récepteur de conversion directe selon la revendication 9, dans lequel le moyen d'estimation est configuré pour :

estimer les déséquilibres de phase dépendants de la fréquence et spécifiques au composant de signal lorsque soit le composant de signal à bande latérale supérieure soit le composant de signal à bande latérale inférieure de la paire domine en puissance l'autre composant ; et
estimer le déséquilibre de phase indépendant de la fréquence à partir d'un ou de plusieurs déséquilibres de phase dépendants de la fréquence et spécifiques au composant par des techniques d'ajustement.

**15.** Récepteur de conversion directe selon la revendication 9, dans lequel le moyen de compensation est configuré pour :

compenser le déséquilibre de phase dépendant de la fréquence et le déséquilibre de gain par filtrage numérique.

**16.** Récepteur de conversion directe selon la revendication 15, dans lequel le moyen de compensation est configuré pour :

compenser le déséquilibre de phase indépendant de la fréquence en soustrayant le déséquilibre de phase indépendante de la fréquence à partir du résultat du filtrage numérique.

Fig. 1A

Fig. 1B

START

200 RECEIVING SIGNAL HAVING MULTIPLE FREQUENCY COMPONENTS

202 MIXING SIGNAL

204 A/D CONVERSION

206 MEASURING POWER OF COMPONENTS

208 DOMINATION IN POWER

YES

210 ESTIMATING PHASE AND GAIN IMBALANCE

212 CORRECTING PHASE AND GAIN IMBALANCE

END

Fig. 2A

START

210A TRANSFORMING INTO FREQUENCY DOMAIN

210B DETERMINING FREQUENCY-DEPENDENT PHASE IMBALANCE

210C DETERMINING FREQUENCY-INDEPENDENT PHASE IMBALANCE

210D DETERMINING GAIN IMBALANCE

210E DETERMINING DESIRED SIGNALS

212A CORRECTING SIGNAL BY FILTERING

212B CORRECTING SIGNAL BY WEIGHTING AND SUBTRACTING

END

Fig. 2B

Fig. 3

**EP 1 515 429 B1**

## REFERENCES CITED IN THE DESCRIPTION

### Patent documents cited in the description

- US 20030072393 A